Europäisches Patentamt

European Patent Office

Office européen des brevets

(19)

(11) Veröffentlichungsnummer: **0 166 814**
**B1**

(12) **EUROPÄISCHE PATENTSCHRIFT**

(45) Veröffentlichungstag der Patentschrift: 18.07.90

(21) Anmeldenummer: 84114903.2

(22) Anmeldetag: 07.12.84

(51) Int. Cl.⁵: **G 01 R 31/28**, G 01 R 31/26,
H 01 J 37/256

(54) **Verfahren und Vorrichtung zur Detektion und Abbildung eines Messpunkts, der eine Spannung wenigstens einer bestimmten Frequenz führt.**

(30) Priorität: 30.05.84 DE 3420272

(43) Veröffentlichungstag der Anmeldung:
08.01.86 Patentblatt 86/02

(45) Bekanntmachung des Hinweises auf die Patenterteilung:
18.07.90 Patentblatt 90/29

(84) Benannte Vertragsstaaten:
BE DE FR GB IT NL

(56) Entgegenhaltungen:
EP-A-0 075 710
DE-A-1 943 140
FR-A-2 312 110

ELECTRONICS, Band 56, Nr. 10, 19. Mai 1983, Seiten 132-136, New York, US; H.P. FEUERBAUM et al.: "Scanned electron beam probe shows surface acoustic waves in action"

(73) Patentinhaber: Siemens Aktiengesellschaft
Wittelsbacherplatz 2
D-8000 München 2 (DE)

(72) Erfinder: Brust, Hans-Detlef
Martin-Luther-Strasse 2
D-6602 Dudweiler (DE)

(56) Entgegenhaltungen:
SOLID-STATE AND ELECTRON DEVICES, Band 3, Nr. 1, Januar 1979, Seiten 25-28; A.R. DINNIS: "Voltage measurements on integrated circuits using the scanning electron microscope"

TM TECHNISCHES MESSEN, Band 48, Nr. 1, Januar 1981, Seiten 29-35, München, DE; P. FAZEKAS: "Elektronenstrahl prüft elektrische Potentiale in integrierten Schaltungen"

EP 0 166 814 B1

**Beschreibung**

Die Erfindung betrifft ein Verfahren und eine Vorrichtung zur Detection von Meßpunkten auf einer Probe, die ein eine erste Frequenz aufweisendes Spannungssignal führen.

Bei fehlerhaftem Verhalten von integrierten Schaltungen besteht der Wunsch, zum Auffinden eines Fehlers das Verhalten der integrierten Schaltung mit dem Soll-Verhalten, so wie es sich aus der Simulation ergibt, zu vergleichen. Hierzu muß u.a. überprüft werden, ob bestimmte interne periodische Signale verschiedener Frequenz an einem Meßpunkt innerhalb der integrierten Schaltung vorhanden sind.

Aus dem Stand der Technik sind bisher drei Verfahren bekannt, mit deren Hilfe überprüft werden kann, ob bestimmte interne periodische Signale bestimmter Frequenz an einem Meßpunkt innerhalb einer integrierten Schaltung vorhanden sind. Aus "Scanning Electron Microscopy" 1975 (part I), Proc. of the Eighth Annual Scanning Electron Microscope Symposium, Chicago, IIT Research Institute, Seiten 465—471, ist das Verfahren des sogenannten "voltage coding" bekannt. Das "voltage coding"-Verfahren bildet die dynamische Potentialverteilung einer integrierten Schaltung auf einem Fernsehmonitor ab. Das "voltage coding"-Verfahren ermöglicht eine zeitliche Zuordnung der Schaltzustände in den verschiedenen Bauelementen und ist daher besonders zur schnellen Funktionsüberprüfung von integrierten Schaltungen geeignet. Das "voltage coding"-Verfahren hat jedoch schwerwiegende Nachteile, die zwangsläufig durch die Zeilenfrequenz des Elektronenstrahls entstehen.

Aus der US-Patentschrift US-A-4 223 220 ist das sogenannte "Logic State Mapping"-Verfahren bekannt. Bei diesem "Logic State Mapping"-Verfahren wird die dynamische Potentialverteilung mit Hilfe eines Stroboskopeffekts abgebildet. Dieses "Logic State Mapping"-Verfahren liefert, verglichen mit dem "voltage coding"-Verfahren bei gleicher Potentialauflösung, eine um Größenordnungen höhere Zeitauflösung. Das "Logic State Mapping"-Verfahren vereinfacht außerdem die Aufzeichnung, da die Abbildungen der dynamischen Potentialverteilung direkt vom Fotobildschirm eines Raster-Elektronenmikroskops abfotografiert werden können. Bei dem "voltage coding"-Verfahren ist dagegen eine Aufzeichnung der dynamischen Potentialverteilung nur mit einem Bandspeicher oder mit Fotos von einem Fernsehmonitor möglich.

Nach einem dritten bekannten Verfahren (Verfahren von J. P. Collin in Proc. of Journées d'Électronique 1983, "Testing Complex Integrated Circuits: A Challenge", herausgegeben vom Swiss Federal Institute of Technology, Lausanne, Schweiz, Seiten 283—298, Titel: "Une Alternative Économique au Contraste de Potentiel Stroboscopique: Le Traitement du Signal d'Electrons Secondaires d'un Microscope a Balayage") wird das Auffinden bestimmter Frequenzen an einem Meßpunkt im Innern einer integrierten Schaltung unter Verwendung eines "lock-in"-Verstärkers durchgeführt. Dabei wird aus einem an einem Meßpunkt im Innern einer integrierten Schaltung gewonnenen Potentialkontrastsignal mit Hilfe des "lock-in"-Verstärkers ein Signal mit der gesuchten Frequenz ausgefiltert und dann die Intensität dieses Signals als Helligkeitsschwankung abgebildet. Bei diesem dritten bekannten Verfahren wird der Elektronenstrahl also nicht gepulst.

Dieses dritte bekannte Verfahren weit zwei Nachteile auf: "lock-in"-Verstärker zeigen bei der Amplitudenmessung meist eine stark begrenzte Ausgangsbandbreite (die Eingangsbandbreite ist bei einem "lock-in"-Verstärker im allgemeinen höher als die Ausgangsbandbreite, so daß die Bandbreiten-Begrenzung am Ausgang keineswegs zu einer Erhöhung der Empfindlichkeit führt). Die begrenzte Ausgangsbandbreite bei einem "lock-in"-Verstärker führt bei dem dritten bekannten Verfahren zu langen Bildaufnahmezeiten von mehreren Minuten Dauer (3 bis 20 min) und zu einer hohen Belastung der Probe, wodurch dieses dritte bekannte Verfahren für einen routinemäßigen Einsatz bei der Suche nach einem Signal mit einer bestimmten Frequenz im Innern einer integrierten Schaltung schlecht geeignet ist. Der zweite Nachteil dieses dritten bekannten Verfahrens besteht darin, daß die maximale Arbeitsfrequenz einerseits durch die Grenzfrequenz des "lock-in"-Verstärkers, andererseits aber durch die Grenzfrequenz der Signalkette des verwendeten Raster-Elektronenmikroskops begrenzt ist. Die Grenzfrequenz eines "lock-in"-Verstärkers beträgt beispielsweise beim Ithaco"lock-in"-Verstärker Typ 391A den Wert 200 kHz. Die Grenzfrequenz der Signalkette, die im wesentlichen aus Detektor, Fotomultiplier und Vorverstärker besteht, beträgt beim ETEC-Autoscan II etwa 1 bis 2 MHz. Ein solches Raster-Elektronenmikroskop ist beispielsweise aus der US-Patentschrift US-A-4 277 679 bekannt. Höhere Arbeitsfrequenzen sind mit diesem dritten bekannten Verfahren nicht erreichbar, so daß die zu untersuchenden integrierten Schaltungen u.U. nicht bei Betriebsfrequenz untersucht werden können. Beispielsweise können integrierte Bipolar-Schaltungen und zahlreiche MOS-Schaltungen Betriebsfrequenzen größer als 2 MHz aufweisen.

Die drei genannten Verfahren, wie sie aus dem Stand der Technik bekannt sind, sind teilweise nur schwer durchführbar, erlauben teilweise nur eine Überprüfung einiger weniger Leitbahnen in der integrierten Schaltung oder sind in ihrem Arbeitsfrequenzbereich stark eingeschränkt, wodurch eine Überprüfung einer integrierten Schaltung unter normalen Betriebsbedingungen häufig nicht möglich ist. Überdies sind die aus dem Stand der Technik bekannten Verfahren teilweise sehr langsam und setzen voraus, daß man die Frequenz eines zu suchenden Signals kennt bzw. daß ein zu dem zu suchenden Signal synchrones Signal von außen zugänglich ist. Ist die Frequenz eines gesuchten Signals unbekannt, so wird die Suche nach einem solchen Signal sehr mühsam und aufwendig. Dies ist z.B. dann der Fall, wenn die Frequenz eines zu suchenden Signals durch eine Teilung durch 255 statt durch eine Teilung durch 256 erzielt wird.

Der vorliegenden Erfindung liegt die Aufgabe zugrunde, ein Verfahren und eine Vorrichtung der eingangs genannten Art anzugeben, mit deren Hilfe es schnell möglich ist, einen Meßpunkt in einer integrierten Schaltung aufzufinden, an dem ein Signal bestimmter Frequenz vorliegt, bzw. bei fehlerhaften elektronischen Bausteinen zu ermitteln, ob eventuell ein Signal einer bestimmten Frequenz ausgefallen ist.

Diese Aufgabe wird erfindungsgemäß durch ein Verfahren nach dem Anspruch 1 und durch eine Vorrichtung nach dem Anspruch 14 gelöst. Ausgestaltungen und Vorteile der Erfindung sind in den Unteransprüchen, der Beschreibung und der Zeichnung dargestellt.

Gegenüber den aus dem Stand der Technik bekannten Verfahren ist ein Verfahren nach der Erfindung wesentlich schneller, belastet die Probe dadurch weniger und ist überdies bis zu sehr hohen Arbeitsfrequenzen einsetzbar, was einen Routine-Einsatz eines Verfahrens nach der Erfindung möglich macht. Ein Verfahren und eine Vorrichtung nach der Erfindung ermöglichen eine schnelle großflächige Durchführung einer Überprüfung einer integrierten Schaltung unter normalen Betriebsbedingungen, falls die Frequenz eines gesuchten Signals bekannt ist, und eine schnelle Darstellung der innerhalb einer integrierten Schaltung vorkommenden Signalfrequenzen, falls eine oder mehrere Frequenzen eines gesuchten Signals nicht bekannt sind.

Bei einem Verfahren und bei einer Vorrichtung nach der Erfindung wird der Elektronenstrahl gepulst. Durch geringen Frequenzversatz derjenigen Frequenz, mit der der Elektronenstrahl gepulst wird, gegenüber der Frequenz eines gesuchten Signals erreicht man, daß durch den an der Oberfläche einer integrierten Schaltung entstehenden Potentialkontrast das gesuchte Signal stets auf eine feste Zwischenfrequenz gemischt wird. Diese feste Zwischenfrequenz kann sodann mit Hilfe eines Bandfilters leicht ausgefiltert und danach demoduliert werden. Da die Signalkette eines Raster-Elektronenmikroskops nur die relativ niedrige feste Zwischenfrequenz übertragen muß, können in einer integrierten Schaltung Signale sehr hoher Frequenz detektiert bzw. abgebildet werden.

Durch Wobbeln derjenigen Frequenz, mit der der Elektronenstrahl ausgetastet wird, kann man das in Frage kommende Frequenzspektrum durchfahren und kann so bei unbekannter Frequenz eines gesuchten Signals die auf einem Meßpunkt oder auf einer Leiterbahn auftretenden Frequenzen feststellen.

Ausführungsbeispiele der Erfindung sind in der Zeichnung dargestellt und werden im folgenden näher beschrieben.

Fig. 1 zeigt eine Vorrichtung zur Abbildung eines Meßpunkts, der ein Signal einer bestimmten Frequenz führt, wie sie aus dem Stand der Technik bekannt ist.

Fig. 2 zeigt eine Vorrichtung zur Detektion und/oder Abbildung eines Meßpunkts, der ein Signal einer bestimmten Frequenz führt, nach der Erfindung.

Fig. 3 zeigt verschiedene Signalverläufe in einer Vorrichtung nach Fig. 2.

Fig. 4 zeigt die Abbildung von Leiterbahnen in einem Mikroprozessor mit einem Verfahren nach der Erfindung im Vergleich zu einer Abbildung, das mit einem Verfahren nach dem Stand der Technik gewonnen worden ist.

Fig. 5 zeigt eine Vorrichtung nach der Erfindung zur Spektralanalyse eines Signals an einem Meßpunkt.

Fig. 6 zeigt eine Vorrichtung nach der Erfindung zur Phasenanalyse eines Signals an einem Meßpunkt.

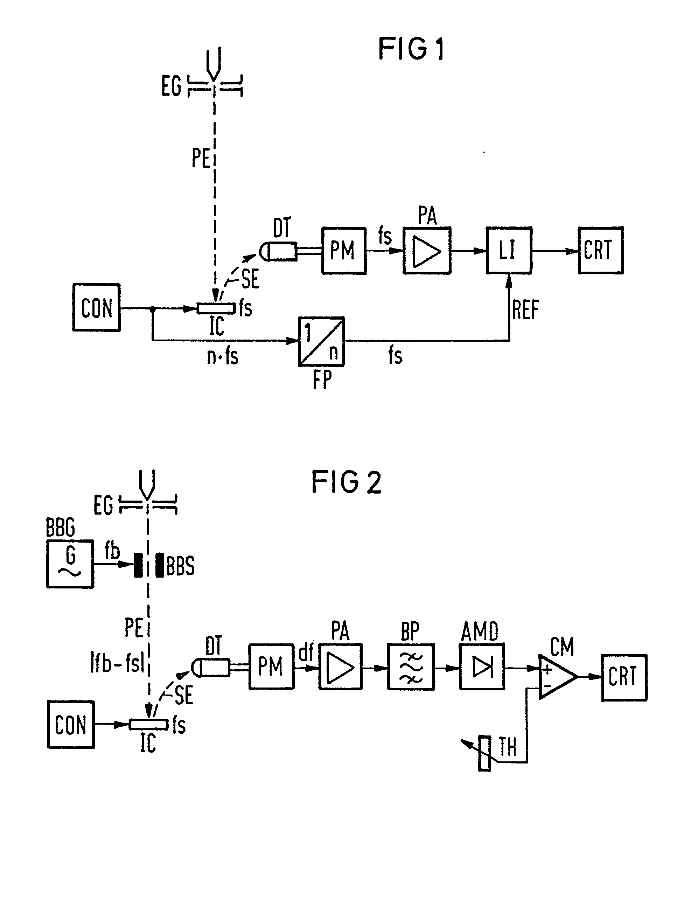

Bei den Fig. 1, 2, 5 und 6 sind gleiche Merkmale bzw. Gegenstände mit gleichen Bezugszeichen versehen.

Obwohl sich die folgenden Ausführungsbeispiele auf ein Elektronenmikroskop beziehen, ist die Erfindung so zu verstehen, daß anstelle von Elektronen auch Ionen oder andere Korpuskeln verwendet werden können, und zwar sowohl als Primärkorpuskeln als auch als Sekundärkorpuskeln.

Fig. 1 zeigt eine Vorrichtung zur Detektion und/oder Abbildung eines Meßpunkts oder einer Leiterbahn, die ein Signal mit einer bestimmten Frequenz führen, so wie sie zur Durchführung eines Verfahrens nach dem oben angegebenen und von Collin veröffentlichten Stand der Technik verwendet wird. Aus einer Elektronenquelle EG treten Primärelektronen PE aus, die auf einen Meßpunkt oder auf eine Leiterbahn innerhalb eines integrierten Schaltkreises IC auftreffen und dort Sekundärelektronen SE auslösen. Diese Sekundärelektronen SE werden in einem Detektor DT nachgewiesen. In Abhängigkeit von dem Sekundärelektronenstrom, der auf den Detektor DT auftrifft, wird in diesem Detektor DT ein Sekundärelektronensignal erzeugt, das zu einem Fotomultiplier PM geführt und dort verstärkt wird. Das im Fotomultiplier PM verstärkte Sekundärelektronensignal wird weiter zu einem Vorverstärker PA geleitet. Das im Vorverstärker PA weiter verstärkte Sekundärelektronensignal gelangt schließlich in einen "lock-in"-Verstärker LI. Das Ausgangssignal dieses "lock-in"-Verstärkers LI kann beispielsweise die Intensität eines Elektronenstrahls in einer Bildröhre CRT steuern.

Die integrierte Schaltung IC wird von einer Ansteuerung CON aus mit einem Signal mit der Frequenz n.fs angetrieben. Dieses Signal mit der Frequenz n.fs wird zusätzlich auch noch einem Frequenzteiler FP zugeführt. Wenn innerhalb der integrierten Schaltung ein Meßpunkt oder eine Leiterbahn abgebildet werden soll, die ein Signal mit der Frequenz fs führt, so teilt dieser Frequenzteiler FP das ihm zugeführte Signal mit der Frequenz n.fs durch die Zahl n. Am Ausgang des Frequenzteilers FP erhält man so ein Signal mit der Frequenz fs, welches als Referenzsignal REF dem "lock-in"-Verstärker LI zugeführt wird.

Wenn der Primärelektronenstrahl auf einen Meßpunkt innerhalb der integrierten Schaltung IC oder innerhalb einer sonstigen Probe trifft und wenn dieser Meßpunkt ein Signal mit der Frequenz fs führt, enthält auch der Sekundärelektronenstrom, der letzten Endes als Sekundärelektronensignal dem "lock-in"-Verstärker LI zugeführt wird, ein Signal mit der Frequenz fs. Aus diesem Sekundärelektronensignal wird daher im "lock-in"-Verstärker LI der Signalanteil mit der gesuchten Frequenz fs ausgefiltert. Die Amplitude dieses Signalanteils mit der Frequenz fs, welches Bestandteil des Sekundärelektronensignals gewesen ist, kann schließlich die Intensität des Elektronenstrahls in der Bildröhre CRT eines Raster-Elektronenmikroskops steuern.

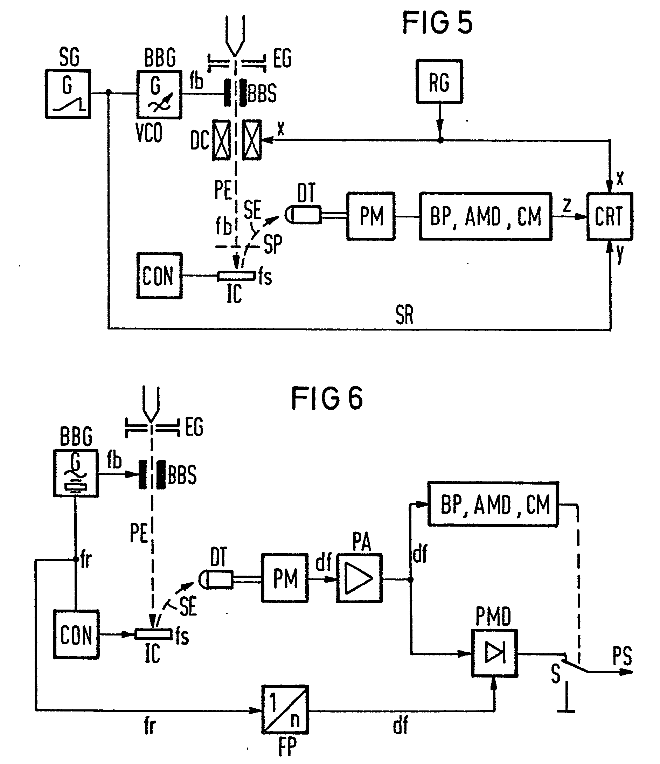

Fig. 2 zeigt eine Vorrichtung nach der Erfindung zur Detektion und/oder Abbildung eines Meßpunkts, der ein Signal einer bestimmten Frequenz führt. Als Grundgerät für eine solche Vorrichtung nach Fig. 2, aber ebenfalls auch für eine Vorrichtung nach Fig. 5 oder Fig. 6, kann ein Raster-Elektronenmikroskop verwendet werden, wie es aus den US-Patentschriften mit den Nummern 4 220 853 bzw. 4 220 854 bzw. 4 277 679 für eine quantitative Potentialmessung und aus der US-Patentschrift 4 223 220 für eine qualitative Potentialmessung bekannt ist. Auch bei den Vorrichtungen nach den Fig. 2, 5 und 6 — ebenso wie einem Verfahren nach der Erfindung — kann selbstverständlich der integrierte Schaltkreis IC durch eine beliebige Probe ersetzt werden, die einen Meßpunkt aufweist, der ein Signal mit einer bestimmten Frequenz führt.

Im Unterschied zu einer Vorrichtung und zu einem Verfahren nach dem genannten Stand der Technik wird bei einer Vorrichtung und bei einem Verfahren nach der Erfindung der Primärelektronenstrahl mit Hilfe eines Strahlaustastsystems BBS mit einer bestimmten Frequenz fb ausgetastet. Ein geeignetes Strahlaustastsystem ist beispielsweise aus der US-Patentschrift 4 169 229 bekannt. Das Strahlaustastsystem BBS wird mit der Frequenz fb von einem Generator BBG angesteuert. Die Frequenz fb ist gegenüber der Frequenz fs, die ein gesuchtes Signal in einem Meßpunkt aufweisen soll, um die Frequenz df versetzt. Die Zahl df ist gleich dem Absolutbetrag der Differenz aus den Zahlen fb und fs. Da der Primärelektronenstrahl mit einer bestimmten Frequenz fb gepulst wird, erhält man ein stroboskopisches Abbildungsverfahren bzw. ein stroboskopisches Detektionsverfahren. Wenn der Meßpunkt ein Signal mit der Frequenz fs führt und wenn die Primärelektronen mit der Frequenz fb gepulst werden, enthält das Sekundärelektronensignal, wie es über den Detektor DT und über den Fotomultiplier PM schließlich zum Ausgang des Vorverstärkers PA gelangt, ein Signal mit der Frequenz df. Ein auf den Vorverstärker PA folgendes Bandpaßfilter BP weist als Mittenfrequenz die Frequenz df auf. Daher filtert das Bandpaßfilter BP genau diese Frequenz df aus dem Frequenzspektrum des Sekundärelektronensignals aus. Bei der praktischen Erprobung einer Vorrichtung nach Fig. 2 fand ein Bandpaßfilter BP mit einer Mittenfrequenz von 50 kHz, mit einer Bandbreite von 3 kHz und mit steil zum Dämpfungsbereich hin abfallenden Flanken Verwendung. Der durch das Bandpaßfilter BP hindurchgelassene Anteil des Sekundärelektronensignals wird in einem AM-Demodulator AMD demoduliert und anschließend an den +Eingang eines Komparators CM angelegt. Der − Eingang dieses Komparators CM ist mit einer variablen Ansprechschwelle TH verbunden. Der Ausgang des Komparators CM steuert die Intensität des Elektronenstrahls einer Bildröhre CRT, die Bestandteil des für eine Vorrichtung nach Fig. 2 verwendeten Raster-Elektronenmikroskops ist.

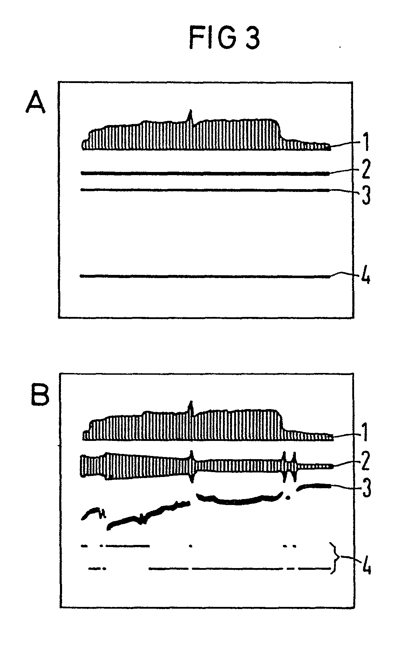

Fig. 3 zeigt zur Verdeutlichung die in einer Signalkette einer Vorrichtung nach Fig. 2 gemessenen Signalformen einmal mit und einmal ohne Frequenzversetzung der Austastfrequenz fb gegenüber der Frequenz fs eines an einem Meßpunkt gesuchten Signals.

Im Figurenteil A sind die Signalverläufe in einer Signalkette einer Vorrichtung nach Fig. 2 für einen solchen Fall dargestellt, bei dem die Frequenzen fs und fb übereinstimmen. Im Figurenteil B der Fig. 3 sind die Signalverläufe in einer Signalkette einer Vorrichtung nach Fig. 2 für einen solchen Fall dargestellt, daß die Austastfrequenz fb um die Frequenz df von der im Signal eines Meßpunkts gesuchten Frequenz fs verschieden ist. In den Figurenteilen A, B der Fig. 3 ist mit 1 jeweils das Signal hinter dem Vorverstärker PA bezeichnet, mit 2 jeweils das Signal am Ausgang des Bandpaßfilters BP, mit 3 jeweils das Signal am Ausgang des Demodulators AMD und mit 4 jeweils das Ausgangssignal des Komparators CM. Wie im Figurenteil A leicht zu erkennen ist, wird bereits durch das Bandpaßfilter BP kein Anteil des Sekundärelektronensignals mehr durchgelassen, wenn die Austastfrequenz fb und die Frequenz fs im Signal des Meßpunkts übereinstimmen. Dagegen wird im Figurenteil B im Ausgangssignal des Komparators CM immer dann ein erhöhter Wert angezeigt, wenn ein Signalanteil, der die Frequenz df aufweist, in ausreichender Höhe im Sekundärelektronensignal vorhanden ist und demzufolge das Bandpaßfilter BP passieren kann.

Bei einem Verfahren, das zu den Aufzeichnungen nach Fig. 3 geführt hat, ist stets ein Bandpaßfilter BP mit einer festen Mittenfrequenz df verwendet worden. Im Figurenteil A der Fig. 3 stimmen die Frequenzen fs und fb stets überein. Daher kann — abgesehen von Signalanteilen, die vom Rauschen herrühren und die mit Hilfe der Ansprechschwelle TH eliminiert werden können — kein Signalanteil aus dem Sekundärelektronensignal das Bandpaßfilter BP passieren und demzufolge ist auch das Ausgangssignal 3 des Demodulators AMD und das Ausgangssignal 4 des Komparators CM stets Null.

Im Figurenteil B der Fig. 3 ist der Absolutbetrag der Differenz zwischen den Frequenzen fs und fb stets gleich der Mittenfrequenz df des Bandpaßfilters BP. Demzufolge ist das Ausgangssignal 2 des Bandpaßfilters BP stets verschieden von Null.

Dies bedeutet, daß stets vom Elektronenstrahl selbst auf die feste Zwischenfrequenz df gemischt wird. Da die Ansprechschwelle TH, die dem Komparator CM zugeordnet ist, im Ausführungsbeispiel nach Fig. 3 zwei Volt beträgt, ist das Ausgangssignal 4 des Komparators CM nur dann von Null verschieden, wenn das Ausgangssignal 2 des Bandpaßfilters BP in seiner Amplitude einen bestimmten Wert übersteigt. Die Ansprechschwelle TH sorgt für besseren Kontrast in der Abbildung.

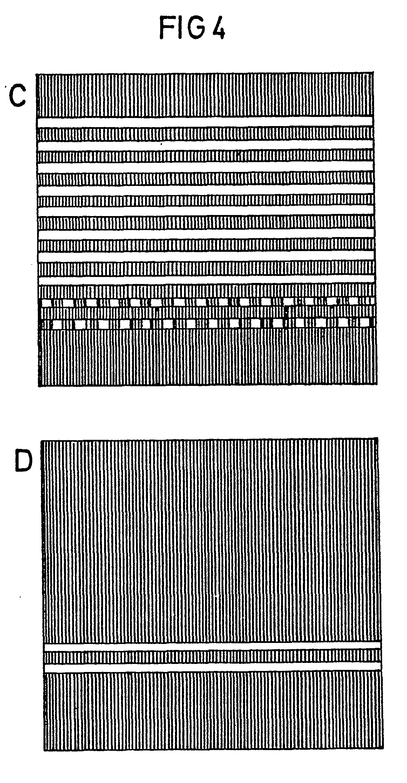

Fig. 4 zeigt zwei Abbildungen von Leiterbahnen in einem Mikroprozessors (Mikroprozessor 8086). Der Figurenteil C der Fig. 4 zeigt einen Ausschnitt der Oberfläche eines Mikroprozessors und zwei Taktleitungen, an denen eine Taktfrequenz von 1 MHz anliegt. Der Figurenteil C der Fig. 4 stellt ein Logikbild dar, wie es nach dem Stand der Technik beispielsweise mit einem Verfahren nach der US-Patentschrift 4 223 220 hergestellt werden kann. Der Figurenteil D der Fig. 4 stellt das mit Hilfe eines Verfahrens nach der Erfindung aufgenommene Vergleichsbild dar. In diesem Bild erscheinen nur diejenigen Leiterbahnen hell, die die Taktfrequenz von 1 MHz führen, während der Rest der Oberfläche des Mikroprozessors dunkel bleibt. Die Frequenz fs ist dabei als die Taktfrequenz des Mikroprozessors vorgegeben und beträgt 1 MHz. Die Austastfrequenz fb der Primärelektronen PE beträgt im dargestellten Versuch fs+df. Dabei kann, wie bereits oben angegeben, ein Bandpaßfilter BP mit einer Mittenfrequenz df von 50 kHz verwendet werden.

Die Bildaufnahmezeiten sind bei einem Verfahren und bei einer Vorrichtung nach der Erfindung im wesentlichen von der Bandbreite des Bandpaßfilters BP und des nachfolgenden AM-Demodulators AMD abhängig. Diese Bildaufnahmezeiten liegen bei der erprobten Meßanordnung zwischen 20 s und 60 s, was einen routinemäßigen Einsatz eines Verfahrens und einer Vorrichtung nach der Erfindung gestattet. Überdies wird durch die geringe Aufnahmezeit und durch das Pulsen des Primärelektronenstrahls die Energiedosis, mit der die Probe beaufschlagt wird, stark verringert und so die Probe geschont. Die höchste mit einem Verfahren und mit einer Vorrichtung nach der Erfindung zu detektierende Frequenz fs wird durch die Grenzfrequenz des Strahlaustastsystems BBS bestimmt und liegt in der Größenordnung von 1 GHz. Daher können beispielsweise integrierte Schaltungen bei ihrer tatsächlichen Betriebsfrequenz überprüft werden.

Zur besseren Orientierung in der zweidimensionalen Abbildung einer Probe kann es von Vorteil sein, das Sekundärelektronen-Topographiesignal in abgeschwächter Form zum Ausgangssignal des Komparators CM hinzuzuaddieren. Wie ein solches Sekundärelektronen-Topographiesignal erzeugt werden kann, ist in Lehrbüchern für Raster-Elektronenmikroskopie zu finden und ist daher dem Fachmann bekannt.

Fig. 5 zeigt eine Vorrichtung nach der Erfindung, mit der eine Spektralanalyse an einem Signal eines Meßpunkts durchgeführt werden kann. Benötigt man keine zweidimensionale Darstellung, sondern interessiert man sich nur für das Verhalten einiger weniger Meßpunkte, so kann eine Art Spektralanalyse durchgeführt werden. Hierzu rastert der Elektronenstrahl ständig entlang einer Linie über die Probe IC, während zugleich der das Strahlaustastsystem BBS ansteuernde Generator BBG den in Frage kommenden Frequenzbereich überstreicht. Zu diesem Zweck erzeugt ein Rampengenerator (Sweep-Generator) SG eine der aktuellen Frequenz fb proportionale Spannung (sweepramp) SR. Diese der aktuellen Frequenz fb proportionale Spannung SR lenkt gleichzeitig den Elektronenstrahl in der Bildröhre CRT in y-Richtung ab. Immer dann, wenn die Austastfrequenz fb einen Wert erreicht, für den der Absolutwert der Differenz zwischen der Austastfrequenz fb und einer Frequenz fs im Signal eines Meßpunkts gleich der Mittenfrequenz df des Bandpaßfilters BP in der Signalkette des Raster-Elektronenmikroskops ist, erscheint auf dem Bildschirm der Bildröhre CRT ein heller Strich und man erhält so eine Darstellung derjenigen Frequenzen fs, die die entlang einer Linie (x-Richtung) abgerasterten Meßpunkte führen.

Die Ablenkung der Primärelektronen PE entlang einer Linie in x-Richtung und die Ablenkung des Elektronenstrahls in der Bildröhre CRT in der x-Richtung wird von einem Rastergenerator RG mittels eines Ablenksignals x erreicht. Zur Ablenkung der Primärelektronen PE entlang einer Linie in der x-Richtung werden mit dem Signal x die Ablenkspulen DC angesteuert.

Der das Strahlaustastsystem BBS ansteuernde Generator BBG ist bei einer Vorrichtung nach Fig. 5 als ein spannungsgesteuerter Oszillator (VCO = voltage controlled oscillator) ausgebildet. Bei spannungsgesteuerten Oszillatoren erfolgt eine Spannungs-Frequenz-Umwandlung, weshalb spannungsgesteuerte Oszillatoren auch Spannungs-Frequenz-Wandler genannt werden.

Die Ansteuerung der Intensitätsmodulation des Elektronenstrahls in der Bildröhre CRT erfolgt über eine Signalkette wie in einer Vorrichtung nach Fig. 2. Diese Signalkette besteht daher aus einem Detektor DT, einem Fotomultiplier PM, gegebenenfalls einem Vorverstärker PA, einem Bandpaßfilter BP mit der Mittenfrequenz df, einem AM-Demodulator AMD und schließlich gegebenenfalls einem Komparator CM. Das Ausgangssignal z dieser Signalkette steuert schließlich die Intensitätsmodulation des Elektronenstrahls in der Bildröhre CRT.

Für sogenannte quantitative Messungen kann in einem Raster-Elektronenmikroskop nach der Fig. 5 ein Spektrometer SP angeordnet werden, wie es beispielsweise aus der US-PS 4 292 519 bekannt ist.

Der Primärelektronenstrahl muß natürlich nicht unbedingt entlang einer Linie (line scan) gerastert werden. Vielmehr kann der Primärelektronenstrahl auch ständig zwischen mehreren Meßpunkten hin und her springen. In beiden Fällen soll die Ablenkung des Primärelektronenstrahls über eine zusammengehörende Gruppe von Meßpunkten hinweg so rasch erfolgen, daß sich während des Abtastens der gesamten Gruppe von zusammengehörenden Meßpunkten die Frequenz fb um insgesamt weniger als 3 kHz ändert.

Die Geschwindigkeitsverhältnisse von Primärstrahlablenkung und Veränderung der Frequenz fb können jedoch auch umgekehrt werden. Die Primärstrahlablenkung kann dabei entweder kontinuierlich oder durch Springen zwischen mehreren Meßpunkten erfolgen. Dazu wird z.B. der Primärelektronenstrahl zunächst auf einen ersten Meßpunkt positioniert und sodann der interessierende Frequenzbereich überstrichen. Daraufhin wird der Primärelektronenstrahl kontinuierlich oder sprungweise auf einen weiteren Meßpunkt positioniert, wo erneut die Austastfrequenz fb über den interessierenden Frequenzbereich hinweg durchgewobbelt wird.

Wenn anstelle des digitalen Ausgangssignals (hinter dem Komparator CM) das analoge Ausgangssignal des AM-Demodulators AMD benutzt wird und wenn die Austastfrequenz fb über einen interessierenden Frequenzbereich hinweg variiert wird, ist man in der Lage, eine wirkliche Spektralanalyse durchzuführen und so Grundschwingungen und Oberschwingungen von Signalen an einem Meßpunkt aufgrund der Intensität der einzelnen Fourier-Komponenten zu unterscheiden. Zur Darstellung wird in der Bildröhre CRT sinnvollerweise das der Frequenz fb proportionale Rampensignal SR in x-Richtung und die Signalhöhe der Fourier-Komponenten in y-Richtung aufgetragen. Dies kann u.U. auch für mehrere Meßpunkte (Leitbahnen) sprungweise oder kontinuierlich durch sprungweise oder kontinuierliche Ablenkung des Primärelektronenstrahls bezüglich der Probenoberfläche erfolgen. Wegen der Ortsabhängigkeit des Potentialkontrastsignals (des Sekundärelektronensignals) sind bei Verwendung einer Vorrichtung nach Fig. 5 ohne Spektrometer SP allerdings nur die Signalhöhen für ein und denselben Meßpunkt (Leiterbahn) vergleichbar. Bei Verwendung eines Spektrometers SP in einer Vorrichtung nach Fig. 5 sind bei Durchführung einer solchen Frequenzanalyse auch die Signalhöhen an verschiedenen Meßpunkten vergleichbar. Daher kann der Primärelektronenstrahl bei einer solchen Frequenzanalyse unter Verwendung eines Spektrometers SP entweder bei einer nahezu festen Austastfrequenz fb mehrere Meßpunkte hintereinander abtasten und dann dieselbe Prozedur für eine davon verschiedene Austastfrequenz fb durchführen, oder der Primärelektronenstrahl kann zunächst einen ersten Meßpunkt abtasten, wobei bereits an diesem ersten Meßpunkt der interessierende Frequenzbereich für die Frequenz fb überstrichen wird, und dieselbe Prozedur sodann an weiteren Meßpunkten wiederholen. Auf diese Weise kann ermittelt werden, in welcher Intensität eine bestimmte Frequenz an verschiedenen Meßpunkten vorhanden ist.

Eine Vorrichtung nach Fig. 6 gestattet eine zusätzliche Phasenanalyse eines Signals an einem Meßpunkt. Neben der Amplitudeninformation kann auch noch die Phaseninformation der Signale, die an verschiedenen Meßpunkten vorliegen, wenigstens bei konstanter Austastfrequenz fb ausgenutzt werden. Hierzu wird ein Phasendemodulator (PM-Demodulator) PMD benutzt. Normalerweise wird als Phasendemodulator PMD eine PLL (phase locked loop)-Schaltung verwendet. PLL-Schaltungen sind dem Fachmann beispielsweise aus einem Frequenzsynthese system für Fernsehgeräte bekannt. Die PLL-Schaltung ermöglicht eine echte Synchrondemodulation. Der Phasendemodulator PMD wird mit der Referenzfrequenz df synchron aus dem Generator BBG oder aus der Probenansteuerung CON gespeist. Um das Phasensignal PS nur bei der gewünschten Frequenz fs zu erhalten, sollte der Ausgang des Phasendemodulators PMD über das Amplitudensignal über einen Schalter S ein-bzw. ausgeschaltet werden. Das Amplitudensignal wird als Ausgangssignal einer Signalkette gewonnen, wie sie bei einer Vorrichtung nach Fig. 2 oder nach Fig. 5 vorhanden ist. Eine solche Signalkette weist Bandpaßfilter BP, AM-Demodulator AMD und einen Komparator CM auf. In dieser Betriebsart müssen selbstverständlich Strahlaustastung und IC-Ansteuerung synchronisiert werden. In der Anordnung nach Fig. 5 geschieht dies durch eine gemeinsame Referenzfrequenz fr.

Wird der Primärelektronenstrahl entlang einer Linie (line scan) abgelenkt, so kann in einem beliebigen Aufzeichnungsgerät, welches nicht notwendig eine Bildröhre sein muß, sondern beispielsweise auch ein Plotter sein kann, das Phasensignal PS über dem Ort der Ablenkung aufgetragen werden. Falls ein Rechner zur Verfügung steht, kann das Phasensignal PS auch in Abhängigkeit von zwei Ortsvariablen (x, y) aufgetragen werden. Der Elektronenstrahl kann ebenfalls von einem Meßpunkt zu einem anderen sprungweise oder kontinuierlich abgelenkt werden.

Die für eine PLL-Schaltung als Phasendemodulator PMD erforderliche Referenzfrequenz df kann beispielsweise dadurch gewonnen werden, daß ein Signal mit einer internen Referenzfrequenz fr aus dem Generator BBG herausgeführt wird und mittels eines Frequenzteilers FP in ein Signal der Frequenz df umgewandelt wird. Ein Signal der Frequenz fr kann auch aus der Ansteuerung CON gewonnen werden.

Das Ausgangssignal des Amplitudendemodulators AMD kann bereits zur Bilderzeugung herangezogen werden, da der Komparator CM nur zur Kontrastverbesserung und Rauschunterdrückung dient.

Nicht nur bei der Phasenanalyse, sondern bei jedem der beschriebenen Verfahren kann die Bildröhre CRT durch ein beliebiges anderes Aufzeichnungsgerät ersetzt werden.

Das Ausgangssignal des Amplitudendemodulators AMD muß nicht notwendigerweise zur Helligkeitsmodulation der Bildröhre CRT benutzt werden. Man kann es auch zur x-Ablenkung der Bildröhre CRT hinzuaddieren und erhält dann eine Art "Wasserfall"-Diagramm. Ein ähnliches Darstellungsverfahren ist in der Elektronenmikroskopie als y-Modulation bekannt.

Die Verwendung eines Spektrometers SP ist nicht nur zur Spannungsmessung nützlich. Benützt man keine Rückkopplungsschleife, sondern legt an das Gegenfeldnetz eines Gegenfeldspektrometers eine konstante Spannung, so entsteht das Detektorsignal nicht mehr durch Potentialkontrast an der Probenoberfläche, sondern durch die Verschiebung der Sekundärelektronen-Energieverteilung. Dadurch werden Störeinflüsse lokaler Felder unterdrückt.

Die Mischung auf eine feste Zwischenfrequenz beruht auf einer nicht-linearen Schaltkennlinie, hervorgerufen durch das Pulsen des Primärelektronenstrahles. Dies kann man aber ebenfalls erreichen, wenn man anstelle der Primärelektronen die Sekundärelektronen bzw. das Sekundärelektronensignal pulst. Dies ist beispielsweise möglich, indem man die Energieschwelle eines Gegenfeldspektrometers mit der Frequenz fb moduliert. Durch Berücksichtigung der Spektrometer-Kennlinie kann man sogar eine sinusförmige Modulation des Sekundärelektronensignals erreichen, und so eventuelle Schwierigkeiten mit Kreuzmodulationsprodukten, wie sie bei dem beschriebenen Verfahren unter Umständen auftreten, da die Primärelektronen beispielsweise auch mit Rechtecksignalen gepulst werden können, vermeiden. Durch die höheren umzuladenden Kapazitäten und die Energiedispersion der Sekundärelektronen ist die Grenzfrequenz beim Pulsen einer Einrichtung in der Signalverarbeitung geringer. Außerdem wird durch das Spektrometer das Gesichtsfeld eingeschränkt. Analog kann man auch den Fotomultiplier zusammen mit einer Gate-Schaltung betreiben oder im Video-Signalpfad pulsen. In diesem Fall wird die Bandbreite allerdings durch den Szintillator des Detektors stark eingeschränkt.

**Patentansprüche**

1. Verfahren zur Detektion von Meßpunkten auf einer Probe (IC) die ein eine erste Frequenz (fs) aufweisendes Spannungssignal führen, dadurch gekennzeichnet,

daß zumindest ein Teilbereich der Probe (IC) mit einem primären Korpuskularstrahl (PE) abgetastet wird,

daß die vom primären Korpuskularstrahl (PE) ausgelösten Sekundärkorpuskeln (SE) mit einem Detektor (DT) nachgewiesen werden, wobei der Detektor (DT) ein erstes Sekundärkorpuskelsignal erzeugt,

daß aus dem ersten Sekundärkorpuskelsignal ein zweites Sekundärkorpuskelsignal abgeleitet wird,

daß die Intensität des primären Korpuskularstrahls (PE) oder die Intensität des Strahls der Sekundärkorpuskeln (SE) oder das erste Sekundärkorpuskelsignal mit einem eine zweite Frequenz (fb) aufweisenden zweiten Signal moduliert wird, wobei die zweite Frequenz (fb) ungleich der ersten Frequenz (fs) des Spannungssignals ist,

daß ein eine dritte Frequenz (df) aufweisendes drittes Signal aus dem zweiten Sekundärkorpuskelsignal ausgefiltert und demoduliert wird, wobei die dritte Frequenz (df) dem Absolutbetrag der Differenz der ersten (fs) und der zweiten Frequenz (fb) entspricht und

daß das demodulierte Signal oder ein aus dem demodulierten Signal erzeugtes Meßsignal in Abhängigkeit vom Ort des primären Korpuskularstrahls (PE) auf der Probe (IC) aufgezeichnet wird.

2. Verfahren nach Anspruch 1, dadurch gekennzeichnet, daß das Meßsignal durch Vergleich des demodulierten Signals mit einer Schwellenspannung (TH) erzeugt wird.

3. Verfahren nach Anspruch 1 oder 2, dadurch gekennzeichnet, daß dem demodulierten Signal oder dem Meßsignal eine Topographiesignal überlagert wird und daß das demodulierte Signal oder das Meßsignal und das Topographiesignal aufgezeichnet werden.

4. Verfahren nach einem der Ansprüche 1 bis 3, dadurch gekennzeichnet, daß das demodulierte Signal oder das Meßsignal in Abhängigkeit vom Ort des primären Korpuskularstrahls (PE) auf der Probe (IC) aufgezeichnet wird.

5. Verfahren zur Detektion von Meßpunkten auf einer Probe (IC) die ein eine erste Frequenz (fs) aufweisendes Spannungssignal führen, dadurch gekennzeichnet,

daß ein Meßpunkt mit einem primären Korpuskularstrahl (PE) beaufschlagt wird,

daß die vom primären Korpuskularstrahl (PE) ausgelösten Sekundärkorpuskeln (SE) mit einem Detektor (DT) nachgewiesen werden, wobei der Detektor (DT) ein erstes Sekundärkorpuskelsignal erzeugt,

daß aus dem ersten Sekundärkorpuskelsignal ein zweites Sekundärkorpuskelsignal abgeleitet wird,

daß die Intensität des primären Korpuskularstrahls (PE) oder die Intensität des Strahls der Sekundärkorpuskeln (SE) oder das erste Sekundärkorpuskelsignal mit einem eine zweite Frequenz (fb) aufweisenden zweiten Signal moduliert wird, wobei die zweite Frequenz (fb) ungleich der ersten Frequenz (fs) des Spannungssignals ist,

daß ein eine dritte Frequenz (df) aufweisendes drittes Signal aus dem zweiten Sekundärkorpuskelsignal ausgefiltert und demoduliert wird, wobei die dritte Frequenz (df) dem Absolutbetrag der Differenz der ersten (fs) und der zweiten Frequenz (fb) entspricht und

das das demodulierte Signal oder ein aus dem demodulierten Signal erzeugtes Meßsignal und ein der zweiten Frequenz (fb) entsprechendes viertes Signal (SR) aufgezeichnet werden.

6. Verfahren nach Anspruch 5, dadurch gekennzeichnet, daß ein der zweiten Frequenz (fb) proportionales viertes Signal (SR) aufgezeichnet wird.

7. Verfahren nach Anspruch 5, dadurch gekennzeichnet, daß das demodulierte Signal oder das Meßsignal in Abhängigkeit von der zweiten Frequenz (fb) dargestellt wird.

8. Verfahren nach einem der Ansprüche 5 bis 7, dadurch gekennzeichnet,

daß der primär Korpuskularstrahl (PE) nacheinander eine Gruppe von Meßpunkten abtastet,

daß die Abtastung der Meßpunkte periodisch wiederholt wird und

daß die zweite Frequenz (fb) während einer jeden Abtastung der Gruppe der Meßpunkte jeweils um maximal 3 kHz geändert wird.

9. Verfahren nach einem der Ansprüche 5 bis 7, dadurch gekennzeichnet, daß der primäre Korpuskularstrahl (PE) solange auf einem Meßpunkt positioniert bleibt, bis die zweite Frequenz (fb) einen gewünschten Frequenzbereich überstrichen hat.

10. Verfahren nach einem der Ansprüche 5 bis 9, dadurch gekennzeichnet, daß das Meßsignal einem analogen Ausgangssignal eines Amplitudendemodulators (AMD) entspricht und in Abhängigkeit von der zweiten Frequenz (fb) aufgezeichnet wird.

11. Verfahren nach einem der Ansprüche 5 bis 9, dadurch gekennzeichnet, daß das demodulierte Signal oder das Meßsignal in Abhängigkeit von der zweiten Frequenz (fb) und vom Ort des primären Korpuskularstrahls (PE) auf der Probe (IC) aufgezeichnet wird.

12. Verfahren nach Anspruch 5, dadurch gekennzeichnet, daß das zweite Sekundärkorpuskelsignal mittels eines Phasendemodulators (PMD) phasendemoduliert wird.

13. Verfahren nach Anspruch 12, dadurch gekennzeichnet, daß das zweite Sekundärkorpuskelsignal auch mittels eines Amplitudendemodulators (AMD) einer Amplitudendemodulation unterworfen wird und daß ein Ausgang des Phasendemodulators (PMD) durch ein Ausgangssignal des Amplitudendemodulators (AMD) geschaltet wird, und daß das geschaltete Ausgangssignal des Phasendemodulators (PMD) das Meßsignal bildet.

14. Vorrichtung zur Detektion von Meßpunkten auf einer Probe (IC), die ein eine erste Frequenz (fs) aufweisendes Spannungssignal führen, gekennzeichnet durch

eine Probenansteuerung (CON),

eine Korpuskularstrahlquelle (EG) zur Erzeugung eines primären Korpuskularstrahls (PE), eine von einem Rastergenerator (RG) angesteuerte Ablenkeinheit (DC),

einen Detektor (DT) zum Nachweis der auf der Probe (IC) ausgelösten Sekundärkorpuskeln (SE) und zur Erzeugung eines ersten Sekundärkorpuskelsignals,

eine Einrichtung (PA) zur Erzeugung eines zweiten Sekundärkorpuskelsignals aus dem ersten Sekundärkorpuskelsignal,

eine Einrichtung (BBG, BBS) zur Modulation der Intensität des primären Korpuskularstrahls (PE) oder eine Einrichtung (SP) zur Modulation der Intensität des Strahls der Sekundärkorpuskeln (SE) oder des ersten Sekundärkorpuskelsignals mit einem eine zweite Frequenz (fb) aufweisenden zweiten Signal, wobei die zweite Frequenz (fb) ungleich der ersten Frequenz (fs) des Spannungssignals ist,

eine mit dem zweiten Sekundärkorpuskelsignal beaufschlagte Signalverarbeitungseinrichtung, die eine Filtereinheit (BP) und eine Demodulatoreinheit (AMD) enthält, wobei die Durchlassfrequenz (df) der Filtereinheit (BP) dem Absolutbetrag der Differenz der ersten (fs) und der zeiten Frequenz (fb) entspricht,

und eine Aufzeichnungseinheit (CRT) zur zur ortsabhängigen oder frequenzabhängigen Aufzeichnung des Ausgangssignals der Signalverarbeitungseinrichtung.

15. Vorrichtung nach Anspruch 14, gekennzeichnet durch ein Bandpaßfilter (BP) als Filtereinheit, einen Amplitudendemodulator als Demodulatoreinheit und ein dem Amplitudendemodulator (AMD) nachgeschalteten Komparator (CM), dessen Ausgang den Ausgang der Signalverarbeitungseinrichtung bildet.

16. Vorrichtung nach Anspruch 14 oder 15, dadurch gekennzeichnet, daß die Einrichtung zur Modulation einen ersten Signalgenerator (BBG) enthält, dessen Ausgangssignal die zweite Frequenz (fb) aufweist, wobei die zweite Frequenz (fb) durch ein Rampensignal (FR) eines den ersten Signalgenerator (BBG) ansteuernden zweiten Signalgenerators (SG) bestimmt ist.

17. Vorrichtung nach einem der Ansprüche 14 bis 16, dadurch gekennzeichnet, daß die Einrichtung zur Modulation der Intensität des Strahls der Sekundärkorpuskeln (SE) ein Gegenfeldspektrometer (SP) enthält.

18. Vorrichtung nach Anspruch 14 oder 15, gekennzeichnet durch einen mit dem zweiten Sekundärkorpuskelsignal beaufschlagten Phasendemodulator (PMD).

19. Vorrichtung nach Anspruch 18, gekennzeichnet durch eine PLL-Schaltung als Phasendemodulator (PMD) und eine Einrichtung (FP) zur Ansteuerung der PPL-Schaltung mit einem Signal der dritten Frequenz (df).

20. Vorrichtung nach Anspruch 18 oder 19, gekennzeichnet durch eine Einrichtung (S) zum Schalten des Ausgangssignals (PS) des Phasendemodulators (PMD), wobei die Einrichtung (S) zum Schalten durch das Ausgangssignal der Signalverarbeitungseinrichtung angesteuert wird und daß das Ausgangssignal des Phasendemodulators (PMD) an einem Eingang der Aufzeichnungseinheit (CRT) anliegt.

**Revendications**

1. Procédé pour détecter, sur un échantillon (IC), des points de mesure qui transmettent un signal de tension possédant une première fréquence (fs), caractérisé par le fait

qu'on explore au moins une zone partielle de l'échantillon (IC) avec un faisceau corpusculaire primaire (PE),

qu'on détecte les corpuscules secondaires (SE), dont l'émission est déclenchée par le faisceau corpusculaire primaire (PE), à l'aide d'un détecteur (DT) qui produit un premier signal des corpuscules secondaires,

qu'on obtient un second signal des corpuscules secondaires à partir du premier signal des corpuscules secondaires,

qu'on module l'intensité du faisceau corpusculaire primaire (PE) ou l'intensité du faisceau des corpuscules secondaires (SE) ou le premier signal des corpuscules secondaires par un second signal possédant une seconde fréquence (fb), la seconde fréquence (fb) étant différente de la première fréquence (fs) du signal de tension,

qu'on sépare par filtrage, du second signal des corpuscules secondaires, un troisième signal possédant une troisième fréquence (df) et qu'on le démodule, la troisième fréquence (df) correspondant à la valeur absolue de la différence entre la première fréquence (fs) et la seconde fréquence (fb), et

qu'on enregistre le signal démodulé ou un signal de mesure produit à partir du signal démodulé, en fonction de l'emplacement du faisceau corpusculaire primaire (PE) sur l'échantillon (IC).

2. Procédé suivant la revendication 1, caractérisé par le fait qu'on obtient le signal de mesure par comparaison du signal démodulé à une tension de seuil (TH).

3. Procédé suivant la revendication 1 ou 2, caractérisé par le fait qu'on superpose un signal de topographie au signal démodulé ou au signal de mesure et qu'on enregistre le signal démodulé ou le signal de mesure et le signal de topographie.

4. Procédé suivant l'une des revendications 1 à 3, caractérisé par le fait qu'on enregistre le signal démodulé ou le signal de mesure en fonction de l'emplacement du faisceau corpusculaire primaire (PE) sur l'échantillon (IC).

5. Procédé pour détecter, sur un échantillon (IC), des points de mesure transmettant un signal de tension possédant une première fréquence (fs), caractérisé par le fait

qu'on charge un point de mesure en utilisant un faisceau corpusculaire primaire (PE),

qu'on détecte les corpuscules secondaires (SE), dont l'émission est déclenchée par le faisceau corpusculaire d primaire (PE), à l'aide d'un détecteur (DT) qui produit un premier signal des corpuscules secondaires,

qu'on obtient un second signal des corpuscules secondaires à partir du premier signal des corpuscules secondaires,

qu'on module l'intensité du faisceau corpusculaire primaire (PE) ou l'intensité du faisceau des corpuscules secondaires (SE) ou le premier signal des corpuscules secondaires par un second signal possédant une seconde fréquence (fb), la seconde fréquence (fb) étant différente de la première fréquence (fs) du signal de tension,

qu'on sépare par filtrage, du second signal des corpuscules secondaires, un troisième signal possédant une troisième fréquence (df) et qu'on le démodule, la troisième fréquence (df) correspondant à la valeur absolue de la différence entre la première fréquence (fs) et la seconde fréquence (fb), et

qu'on enregistre le signal démodulé ou un signal de mesure produit à partir du signal démodulé, en fonction de l'emplacement du faisceau corpusculaire primaire (PE) sur l'échantillon (IC).

6. Procédé suivant la revendication 5, caractérisé par le fait qu'on enregistre un quatrième signal (SE) proportionnel à la seconde fréquence (fb).

7. Procédé suivant la revendication 5, caractérisé par le fait qu'on représente le signal démodulé ou le signal de mesure en fonction de la seconde fréquence (fb).

8. Procédé suivant l'une des revendications 5 à 7, caractérisé par le fait

que le faisceau corpusculaire primaire (PE) explore successivement un groupe de points de mesure,

qu'on répète périodiquement l'exploration des points de mesure, et

qu'on modifie respectivement d'une valeur égale au maximum à 3 kHz la seconde fréquence (fb) pendant chaque exploration du groupe des points de mesure.

9. Procédé suivant l'une des revendications 5 à 7, caractérisé par le fait que le faisceau corpusculaire primaire (PE) reste positionné sur un point de mesure jusqu'à ce que la seconde fréquence (fb) ait dépassé une gamme de fréquences désirée.

10. Procédé suivant l'une des revendications 5 à 9, caractérisé par le fait que le signal de mesure correspond à un signal de sortie analogique d'un démodulateur d'amplitude (AMD) et qu'on l'enregistre en fonction de la seconde fréquence (fb).

11. Procédé suivant l'une des revendications 5 à 9, caractérisé par le fait qu'on enregistre le signal démodulé ou le signal de mesure en fonction de la seconde fréquence (fb) et de l'emplacement du faisceau corpusculaire primaire (PE) pour l'échantillon (IC).

12. Procédé suivant la revendication 5, caractérisé par le fait qu'on applique une démodulation de phase au second signal des corpuscules secondaires à l'aide d'un démodulateur de phase (PMD).

13. Procédé suivant la revendication 12, caractérisé par le fait qu'on soumet le second signal des corpuscules secondaires également à une démodulation d'amplitude à l'aide d'un démodulateur d'amplitude (AMD) et qu'on commute une sortie du démodulateur de phase (PMD) au moyen d'un signal de sortie du démodulateur d'amplitude (AMD) et que le signal de sortie commuté du démodulateur de phase (PMD) constitue le signal de mesure.

14. Dispositif pour détecter, sur un échantillon (IC), des points de mesure qui transmettent un signal de tension possédant une première fréquence (fs), caractérisé par

un dispositif (CON) de commande de l'échantillon,

une source (EG) de faisceau corpusculaire servant à produire un faisceau corpusculaire primaire (PE),

une unité de déviation (DC) commandée par un générateur de trames (RG),

un détecteur (DT) servant à détecter les corpuscules secondaires (SE), dont l'émission est déclenchée sur l'échantillon (IC), et produire un premier signal des corpuscules secondaires,

un dispositif (PE) servant à produire un second signal des corpuscules secondaires, à partir du premier signal des corpuscules secondaires,

un dispositif (BBG, BBS) servant à moduler l'intensité du faisceau corpusculaire primaire (PE) ou un dispositif (SP) servant à moduler l'intensité du faisceau des corpusculaires secondaires (SE) ou du premier signal des corpuscules secondaires avec un second signal possédant une seconde fréquence (fb), la seconde fréquence (fb) étant différente de la première fréquence (fs) du signal de tension,

un dispositif de traitement des signaux, qui est chargé par le second signal de corpuscules secondaires et contient une unité formant filtre (BP) et une unité formant démodulateur (AMD), la fréquence de transmission (df) de l'unité formant filtre (BP) correspondant à la valeur absolue de la différence entre la première fréquence (fs) et la seconde fréquence (fb), et

une unité d'enregistrement (CRT) servant à enregistrer, en fonction de l'emplacement ou de la fréquence, le signal de sortie du dispositif de traitement de signaux.

15. Dispositif suivant la revendication 14, caractérisé par un filtre passe-bande (BP) constituant l'unité formant filtre, un démodulateur d'amplitude constituant l'unité formant démodulateur et un comparateur (CM), branché en aval du démodulateur d'amplitude (AMD) et dont la sortie forme la sortie du dispositif de traitement de signaux.

16. Dispositif suivant la revendication 14 ou 15, caractérisé par le fait que le dispositif de modulation contient un premier générateur de signaux (BBG), dont le signal de sortie possède la seconde fréquence (fb), cette seconde fréquence (fb) étant déterminée par un signal en rampe (FR) d'un second générateur de signaux (SG) commandant le premier générateur de signaux (BBG).

17. Dispositif suivant l'une des revendications 14 à 16, caractérisé par le fait que le dispositif servant à moduler l'intensité du faisceau des corpuscules secondaires (SE) contient un spectromètre à champ inverse (SP).

18. Dispositif suivant la revendication 14 ou 15, caractérisé par un démodulateur de phase (PMD), chargé par le second signal des corpuscules secondaires.

19. Dispositif suivant la revendication 18, caractérisé par un circuit PLL utilisé comme démodulateur de phase (PMD), et un dispositif (FP) servant à commander le circuit PLL avec un signal possédant la troisième fréquence (df).

20. Dispositif suivant la revendication 18 ou 19, caractérisé par un dispositif (S) servant à commuter le signal de sortie (PS) du démodulateur de phase (PMD), le dispositif (S) étant commandé, pour la commutation, par le signal de sortie du dispositif de traitement de signaux, et que le signal de sortie du démodulateur de phase (PMD) s'applique à une entrée de l'unité d'enregistrement (CRT).

**Claims**

1. Method of detecting measuring locations on a specimen (IC), which carry a voltage signal of a first frequency (fs), characterized in that at least a subregion of the specimen (IC) is scanned with a primary particle beam (PE), in that the secondary particles (SE) liberated by the primary particle beam (PE) are detected with a detector (DT), the detector (DT) generating a first secondary particle signal, in that a second secondary particle signal is derived from the first secondary particle signal, in that the intensity of the primary particle beam (PE) or the intensity of the beam of the secondary particles (SE) or the first secondary particle signal is modulated with a second signal having a second frequency (fb), the second frequency (fb) being different from the first frequency (fs) of the voltage signal, in that a third signal having a third frequency (df) is filtered out of the second secondary particle signal and demodulated, the third frequency (df) corresponding to the absolute value of the difference of the first (fs) and the second frequency (fb) and in that the demodulated signal or a measuring signal generated from the demodulated signal is recorded as a function of the location of the primary particle beam (PE) on the specimen (IC).

2. Method according to Claim 1, characterized in that the measuring signal is generated by comparing the demodulated signal with a threshold voltage (TH).

3. Method according to Claim 1 or 2, characterized in that a topography signal is superimposed on the demodulated signal or on the measuring signal, and in that the demodulated signal or the measuring signal and the topography signal are recorded.

4. Method according to one of Claims 1 to 3, characterized in that the demodulated signal or the measuring signal is recorded as a function of the location of the primary particle beam (PE) on the specimen (IC).

5. Method of detecting measuring locations on a specimen (IC), which carry a voltage signal of a first frequency (fs), characterized in that a primary particle beam (PE) is applied to a measuring location, in that the secondary particles (SE) liberated by the primary particle beam (PE) are detected with a detector (DT), the detector (DT) generating a first secondary particle signal, in that a second secondary particle signal is derived from the first secondary particle signal, in that the intensity of the primary particle beam (PE) or the intensity of the beam of the secondary particles (SE) or the first secondary particle signal is modulated with a second signal having a second frequency (fb), the second frequency (fb) being different from the first frequency (fs) of the voltage signal, in that a third signal having a third frequency (df) is filtered out of the second secondary particle signal and demodulated, the third frequency (df) corresponding to the absolute value of the difference of the first (fs) and the second frequency (fb), and in that the demodulated signal or a measuring signal generated from the demodulated signal and a fourth signal (SR) corresponding to the second frequency (fb) are recorded.

6. Method according to Claim 5, characterized in that a fourth signal (SR) proportional to the second frequency (fb) is recorded.

7. Method according to Claim 5, characterized in that the demodulated signal or the measuring signal is represented as a function of the second frequency (fb).

8. Method according to one of Claims 5 to 7, characterized in that the primary particle beam (PE) successively scans a group of measuring locations, in that the scanning of the measuring locations is repeated periodically, and in that during each scanning of the group of the measuring locations the second frequency (fb) is varied in each case by at most 3 kHz.

9. Method according to one of Claims 5 to 7, characterized in that the primary particle beam (PE) remains positioned on a measuring location until the second frequency (fb) has covered a desired frequency band.

10. Method according to one of Claims 5 to 9, characterized in that the measuring signal corresponds to an analogous output signal of an amplitude demodulator (AMD) and is recorded as a function of the second frequency (fb).

11. Method according to one of Claims 5 to 9, characterized in that the demodulated signal or the measuring signal is recorded as a function of the second frequency (fb) and of the location of the primary particle beam (PE) on the specimen (IC).

12. Method according to Claim 5, characterized in that the second secondary particle signal is phase-demodulated by means of a phase demodulator (PMD).

13. Method according to Claim 12, characterized in that the second secondary particle signal is also subjected to an amplitude demodulation by means of an amplitude demodulator (AMD), and in that an output of the phase demodulator (PMD) is switched through an output signal of the amplitude demodulator (AMD), and in that the switched output signal of the phase demodulator (PMD) forms the measuring signal.

14. Apparatus for detecting measuring locations on a specimen (IC), which carry a voltage signal of a first frequency (fs), characterized by a specimen control (CON), a particle beam source (EG) for generating a primary particle beam (PE), a deflection unit (DC) controlled by a raster generator (RG), a detector (DT) for detecting the secondary particles (SE) liberated on the specimen (IC) and for generating a first secondary particle signal, a device (PA) for generating a second secondary particle signal from the first secondary particle signal, a device (BBG, BBS) for modulating the intensity of the primary particle beam (PE) or a device (SP) for modulating the intensity of the beam of the secondary particles (SE) or of the first secondary particle signal with a second signal having a second frequency (fb), the second frequency (fb) being different from the first frequency (fs) of the voltage signal, a signal processing device to which the second secondary particle signal is applied and which contains a filter unit (BP) and a demodulator unit (AMD), the pass frequency (df) of the filter unit (BP) corresponding to the absolute value of the difference of the first (fs) and the second frequency (fb), and a recording unit (CRT) for recording the output signal of the signal processing device in a manner dependent upon location or frequency.

15. Apparatus according to Claim 14, characterized by a bandpass filter (BP) as filter unit, an amplitude demodulator as demodulator unit and a comparator (CM); which is connected downstream of the amplitude demodulator (AMD) and whose output forms the output of the signal processing device.

16. Apparatus according to Claim 14 or 15, characterized in that the device for modulating contains a first signal generator (BBG) whose output signal has the second frequency (fb), the second frequency (fb) being determined by a ramp signal (FR) of a second signal generator (SG) controlling the first signal generator (BBG).

17. Apparatus according to one of Claims 14 to 16, characterized in that the device for modulating the intensity of the beam of the secondary particles (SE) contains an opposing-field spectrometer (SP).

18. Apparatus according to Claim 14 or 15, characterized by a phase demodulator (PMD) to which the second secondary particle signal is applied.

19. Apparatus according to Claim 18, characterized by a PLL as phase demodulator (PMD) and a device (FP) for controlling the PPL circuit with a signal of the third frequency (df).

20. Apparatus according to Claim 18 or 19, characterized by a device (S) for switching the output signal (PS) of the phase demodulator (PMD), the device (S) for switching being controlled by the output signal of the signal processing device, and in that the output signal of the phase demodulator (PMD) occurs at an input of the recording unit (CRT).

FIG 1

FIG 2

1

# FIG 3

# FIG 4

C

D

## FIG 5

## FIG 6